# EUROPEAN PATENT SPECIFICATION

(11) **EP 3 534 196 B1**
(45) Date of publication and mention of the grant of the patent: **22.01.2025**
(21) Application number: 16922499.5
(22) Date of filing: 25.11.2016
(51) Int. Cl.: G02B 6/42, H01L 21/50, H01L 23/04, H01L 23/055, H01L 23/057, H01L 23/10

(54) **OPTICAL COMPONENT PACKAGING APPARATUS, OPTICAL MODULE AND OPTICAL COMPONENT PACKAGING METHOD**
VERPACKUNGSVORRICHTUNG FÜR OPTISCHE KOMPONENTE, OPTISCHES MODUL UND VERPACKUNGSVERFAHREN FÜR OPTISCHE KOMPONENTE
APPAREIL D'EMBALLAGE DE COMPOSANT OPTIQUE, MODULE OPTIQUE ET PROCÉDÉ DE CONDITIONNEMENT DE COMPOSANT OPTIQUE

(43) Date of publication of application: 04.09.2019
(73) Proprietor: Huawei Technologies Co., Ltd., Longgang District Shenzhen, Guangdong 518129 (CN)
(72) Inventor: GAO, Lei, Shenzhen Guangdong518129 (CN); SONG, Xiaolu, Shenzhen Guangdong 518129 (CN); DONG, Zhen, Shenzhen Guangdong 518129 (CN); ZHAO, Qing, Shenzhen Guangdong 518129 (CN); ZENG, Li, Shenzhen Guangdong 518129 (CN)
(74) Representative: Gill Jennings & Every LLP
(86) International application number: PCT/CN2016/107333
(87) International publication number: WO 2018/094700

(56) References cited:
- CN-A- 101 351 733
- CN-A- 101 399 430
- CN-A- 101 765 794
- CN-A- 102 692 684
- CN-A- 103 489 834
- US-A1- 2003 215 194
- US-A1- 2004 052 480
- US-A1- 2007 009 212
- US-A1- 2009 169 219
- US-A1- 2015 036 467
- US-A1- 2016 291 269

## Description

### TECHNICAL FIELD

This application relates to the communications field, and in particular, to an optical component packaging apparatus, an optical module, and an optical component packaging method.

### BACKGROUND

With rapid development of Next Generation Internet, mobile communications, cloud computing, and big data technologies, technologies of optical interconnection, optical communications, and optical processing using light as an information carrier become a basis of development of an information society and an intelligent city.

Light becomes an information carrier by using an optical component. Optical components are classified into an active optical component and a passive optical component. The active optical component is an optical component that converts an electrical signal into an optical signal, or converts an optical signal into an electrical signal, and needs to be driven by additional energy to work. The passive optical component is an optical component that does not need to be driven by additional energy to work.

To meet a requirement for reliability during use of an optical component, the optical component needs to be packaged. Especially for an active optical component, it is extremely easy for the active optical component to fail in a non-hermetic environment under the action of oxygen and water vapor. Therefore, hermetic package of the active optical component is very important for reliability of the active optical component.

Currently, common structures of packaging apparatuses for hermetically packaging an active optical component include:
1. The packaging apparatus includes a metal case. The optical component is disposed in the metal case and is sealed. Costs of the metal case in the packaging apparatus are relatively high, increasing production costs of an optical component product, and it is relatively difficult to implement sealing design for a fiber outlet.
2. The packaging apparatus includes a packaging cover. A packaging cavity is formed by one or two packaging covers that are connected to an optical component in a matching manner, and the packaging covers are sealed. Production costs of the packaging apparatus are relatively low, but it is relatively difficult to implement optical coupling of the optical component.

Therefore, how to hermetically seal an optical component with low costs and implement optical coupling of the optical component has become a technical problem urgently needing to be resolved by a person skilled in the art.

US2016/0291269 A1 discloses photonic integrated circuit chip packaging.

US2015/0036467 A1 discloses a capping method for laser diode protection.

US2004/0052480 A1 discloses micro-hermetic packaging of optical devices.

US 2007/009212 A1 discloses an optoelectronic module that includes a first sub-module and a second sub-module. The first sub-module has a surface with a cavity formed therein, and includes an integrated waveguide provided with a first optical port accessible from the cavity. The second sub-module faces the first sub-module. A metallic wall extends from the first sub-module to the second sub-module, and surrounds the cavity to define a hermetically closed chamber. An optoelectronic device is coupled to at least one of the first and second sub-modules, and is included in the chamber.

### SUMMARY

This application provides an optical component packaging apparatus, an optical module, and an optical component packaging method according to the claims, to resolve a prior-art problem that an optical component packaging apparatus can implement neither hermetic package of an optical component with low costs nor optical coupling of the optical component.

In the optical component packaging apparatus according to claim 1, the optical component is packaged by using the packaging cavity that is formed through matching by the two packaging substrates. Compared with the prior art in which a packaging apparatus having a metal case is used, the optical component packaging apparatus according to claim 1 has lower costs, the optical waveguide that is configured to couple to the optical component and perform optical coupling is disposed in the packaging substrate, and the optical component in the packaging cavity can implement optical switching with the outside by using the optical waveguide, so that optical input and output are implemented while the optical component is sealed. Therefore, based on the optical component packaging apparatus, a problem of hermetic package of the optical component with low costs and a problem of the optical coupling of the optical component are resolved.

### BRIEF DESCRIPTION OF DRAWINGS

To describe the technical solutions in the embodiments of the present invention more clearly, the following briefly describes the accompanying drawings required for the embodiments.
FIG. 1 is an exploded schematic structural view of an optical component packaging apparatus according to Embodiment 1;
FIG. 2 is a schematic structural diagram of a first packaging substrate according to Embodiment 1;
FIG. 3 is a schematic structural diagram of a second packaging substrate according to Embodiment 1;
FIG. 4 is a cross-sectional schematic structural view of the optical component packaging apparatus according to Embodiment 1;
FIG. 5 is a cross-sectional schematic structural view of the optical component packaging apparatus according to Embodiment 1;
FIG. 6 is a flowchart of an optical component packaging method according to Embodiment 3; and
FIG. 7 is a flowchart of another optical component packaging method according to Embodiment 3.

### DESCRIPTION OF EMBODIMENTS

The following describes the technical solutions in the embodiments of the present invention with reference to the accompanying drawings in the embodiments of the present invention.

### Embodiment 1

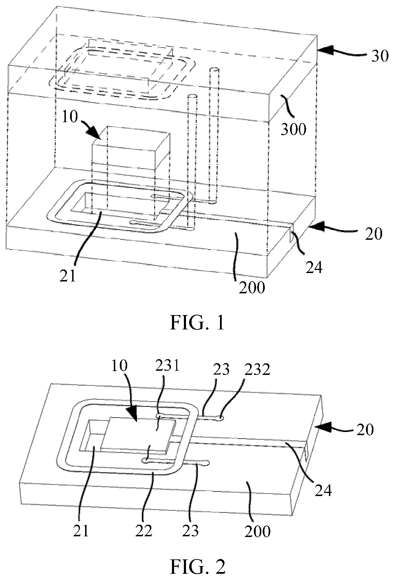

FIG. 1 is an exploded schematic structural view of an optical component packaging apparatus according to Embodiment 1. The optical component packaging apparatus includes an optical component 10, and a first packaging substrate 20 and a second packaging substrate 30 that are disposed opposite to each other. The optical component 10 in this embodiment may be an active optical component or a passive optical component. When the optical component is an active optical component, the optical component 10 may be a light source or an optical detector, and may be specifically, for example, a laser chip or a detector chip. In a specific implementation, areas and thicknesses of the first packaging substrate 20 and the second packaging substrate 30 are set based on an outline dimension of a corresponding optical component, and sizes of the two packaging substrates may be the same or may be different.

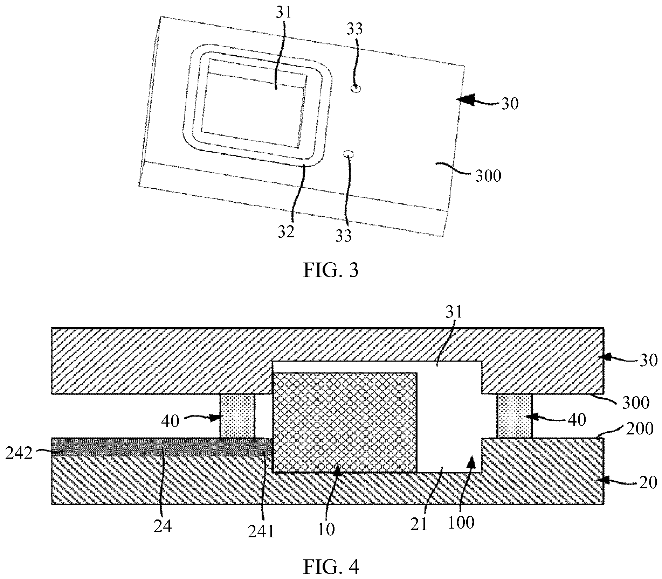

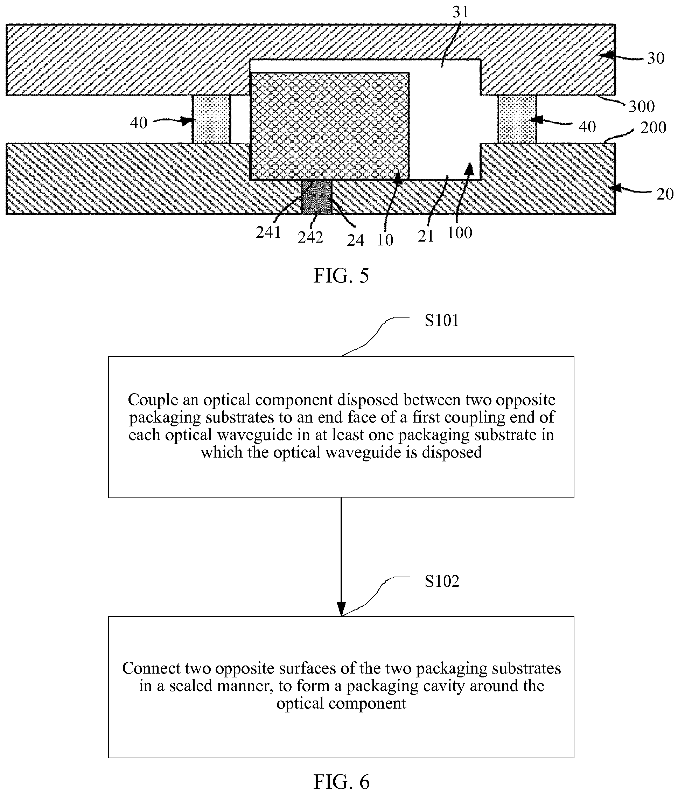

FIG. 4 and FIG. 5 each are a cross-sectional schematic structural view of the optical component packaging apparatus according to Embodiment 1. A packaging cavity 100 filled with a protective gas is formed between the two packaging substrates, and the optical component 10 is disposed in the packaging cavity 100. It should be noted that, the packaging cavity 100 is a sealed hollow structure formed between the two packaging substrates, and the optical component is packaged in the sealed hollow structure, to isolate external water vapor and oxygen. For a specific manner of disposing the packaging cavity 100, refer to FIG. 4 and FIG. 5. The first packaging substrate 20 includes a surface 200, and the second packaging substrate 30 includes a surface 300. The surface 200 and the surface 300 are disposed opposite to each other, and the surface 200 and the surface 300 each are provided with a groove, that is, the first packaging substrate 20 is provided with a first groove 21, and the second packaging substrate 30 is provided with a second groove 31. The two grooves accommodate the optical component, and peripheries of the two grooves are connected by using a sealant 40, to form the packaging cavity. In examples that do not fall under the scope of the claims, there may be no groove provided between the two packaging substrates, and only a sealant is used for connection, or a spacer having a specific thickness is used for connection, to form the packaging cavity. The optical component in the packaging cavity may be fastened by using an adhesive and the like. Alternatively, in examples that do not fall under the scope of the claims, a groove may be provided on either of the substrates, parts that are of the two substrates and that are located around the groove are attached to each other to seal the groove, to form the packaging cavity. The protective gas may be a common gas such as helium, argon, and nitrogen, and may be specifically selected based on a production process. It should be noted that, in an implementation process that does not fall under the scope of the claims, there may be no protective gas filled in the packaging cavity 100, instead, the packaging cavity 100 is set to be vacuum, and the vacuum packaging cavity can also package the optical component.

Still referring to FIG. 1, an optical waveguide 24 is disposed in the first packaging substrate 20, and the optical waveguide 24 has two coupling ends. Referring to FIG. 4 and FIG. 5, an end face of a first coupling end 241 of the optical waveguide 24 is disposed on an inner surface of the packaging cavity 100 and is coupled to the optical component 10, and an end face of a second coupling end 242 of the optical waveguide 24 is disposed on an external surface of the first packaging substrate 20. The optical waveguide 24 extends in the first packaging substrate 20, to guide light to or out of the packaging cavity 100, so that the optical component 10 in the packaging cavity 100 performs optical switching with the outside of the packaging cavity 100. In a specific implementation, when the optical component 10 is an active optical component, for example, when the optical component 10 is a light source, the first coupling end 241 of the optical waveguide 24 is an input end, and the second coupling end 242 is an output end. If the optical component 10 is an optical detector, the first coupling end 241 of the optical waveguide 24 is an output end, and the second coupling end 242 is an input end. In another implementation, the first packaging substrate 20 and the second packaging substrate 30 may each be provided with an optical waveguide 24, and there may be at least two optical waveguides 24 in each packaging substrate.

For a method of disposing the optical waveguide 24, refer to FIG. 4 and FIG. 5. In an implementation, refer to FIG. 4, an extension direction of the optical waveguide 24 is parallel to the first packaging substrate 20, the end face of the first coupling end 241 of each optical waveguide 24 is disposed on a side wall of the first groove 21, and the end face of the second coupling end 242 of each optical waveguide 24 is disposed on a side surface of the first packaging substrate 20, so that an optical signal may be input to or output from the optical component 10 from a side surface of the second packaging substrate 30. It should be noted that, in this implementation, an optical input/output port of the optical component 10 faces toward the side wall of the first groove 21. In addition to accommodating the optical component 10, the first groove 21 can further enable the optical input/output port of the optical component 10 to butt the end face of the first coupling end 241 of the optical waveguide 24.

In another implementation, referring to FIG. 5, an extension direction of each optical waveguide 24 is perpendicular to the first packaging substrate 20, the end face of the first coupling end 241 of the optical waveguide 24 is disposed on a surface that is of the first packaging substrate 20 and that is in the packaging cavity 100, and the end face of the second coupling end 242 of the optical waveguide 24 is disposed on a surface that is of the first packaging substrate 20 and that is away from the packaging cavity 100, so that an optical signal may be input to or output from the optical component 10 from the bottom of the second packaging substrate 30. It should be noted that, in this implementation, the optical component 10 may not be fastened by using the first groove 21, and the first packaging substrate 20 may be provided with no groove.

The two packaging substrates each are provided with an optical waveguide 24. Alternatively, when there are a plurality of optical waveguides 24, the optical waveguides 24 may all be disposed in the foregoing two manners.

In a specific implementation, the sealant 40 may be implemented by using an adhesive. To simplify a packaging process of the two packaging substrates, in a specific implementation, to simplify a connection structure between the two packaging substrates, refer to FIG. 2 and FIG. 3. FIG. 2 is a schematic structural diagram of the first packaging substrate 20 according to Embodiment 1. FIG. 3 is a schematic structural diagram of the second packaging substrate 30 according to Embodiment 1. A first ring pad 22 is disposed on the surface 200 of the first packaging substrate 20, a second ring pad 32 is disposed on the surface 300 of the second packaging substrate 30, and the first ring pad 22 and the second ring pad 32 each are disposed around the optical component. The sealant 40 is a solder, and the solder is connected to the first ring pad 22 and the second ring pad 32 in a sealed manner, to butt the first packaging substrate 20 and the second packaging substrate 30.

In the connection process of the first packaging substrate 20 and the second packaging substrate 30, the solder may be disposed on the first ring pad 22 or the second ring pad 32 in advance, and the solder is melted through reflow soldering, to connect the first ring pad 22 and the second ring pad 32. Soldering between the first ring pad 22 and the second ring pad 32 may be integrated with another soldering process of the optical component, to further reduce production costs of the optical component packaging apparatus.

In a specific implementation, the solder may be a copper-zinc alloy solder, a silver-copper alloy solder, or a silver-copper-zinc alloy solder that is commonly used in a reflow soldering process, and air-tightness of the solder is superior to that of an adhesive.

In another implementation that does not fall under the scope of the claims, the two packaging substrates may be directly connected in a manner such as splicing, or the sealant 40 is replaced with a spacer having a specific thickness.

When the optical component 10 is an active optical component, power needs to be supplied to the optical component, and the first packaging substrate 20 and the second packaging substrate 30 should be provided with a power supply circuit. A power output end of the power supply circuit is located in the packaging cavity 100 and is connected to the optical component, and a power input end of the power supply circuit is located outside the packaging cavity 100.

In a specific implementation, referring to FIG. 2 and FIG. 3, the first packaging substrate 20 and the second packaging substrate 30 are provided with a power supply circuit. The power supply circuit specifically includes an electrode 23 disposed on the first packaging substrate 20 and a power-on interface 33 disposed on the second packaging substrate 30. Referring to FIG. 2, an output end 231 of the electrode 23 is located in a region surrounded by the first ring pad 22, and is connected to the optical component 10 by using a lead, and an input end 232 of the electrode 23 is located outside the region surrounded by the first ring pad 22. Referring to FIG. 1, when the first packaging substrate 20 and the second packaging substrate 30 are butted, the input end 232 of the electrode 23 is connected to the power-on interface 33. The power-on interface 33 may be specifically implemented by disposing a pad on the second packaging substrate 30. In a specific implementation, referring to FIG. 2, the output end 231 of the electrode 23 is connected to the optical component 10 by using a lead. In another implementation, the optical component 10 may be directly connected to the output end of the electrode 23. Specifically, the optical component 10 may be is mounted inversely on the first packaging substrate 20.

The foregoing power supply circuit may alternatively be disposed only on the first packaging substrate 20 or the second packaging substrate 30, that is, both the electrode and the power-on interface may be disposed on a same packaging substrate.

In order that the electrode 23 extending into the region surrounded by the first ring pad 22 or the second ring pad 32 causes no impact on sealing performance of the packaging cavity 100, the electrode 23 of the power supply circuit is disposed between the ring pad and the packaging substrate on which the electrode 23 is located. In a specific implementation, the ring pad and the electrode of the power supply circuit may be disposed at different layers, that is, a pad layer and a circuit layer are formed on a surface of the packaging substrate, and the pad layer is located above the circuit layer.

In a specific implementation, the optical component 10 may be coupled to the optical waveguide 24 through butt-coupling, grating coupling, or evanescent wave coupling, and the coupling manner is specifically selected based on the production costs of the optical component packaging apparatus and required coupling efficiency.

In order that multi-channel integration and multi-function integration are implemented on the first packaging substrate 20 or the second packaging substrate 30, the optical component 10 packaged in the optical component packaging apparatus includes at least one of the following components:
a modulator, a filter, a beamsplitter, a beam combiner, a detector, or a light source.

In a specific implementation, based on an actual requirement, some optical components that do not need to be hermetically packaged may be disposed outside the packaging cavity 100, to simplify the production process of the optical component packaging apparatus.

In a specific implementation, when the optical waveguide 24 and the electrode 23 need to be disposed on a packaging substrate, for example, the first packaging substrate 20 in this embodiment, the packaging substrate is manufactured by using a material that can manufacture an optical waveguide and an electrode, for example, the packaging substrate may be a silicon on insulator substrate, a glass substrate, a lithium niobate substrate, or a polymer substrate. When one of the two packaging substrates, for example, the second packaging substrate 30 in this embodiment, is provided with no optical waveguide 24, the packaging substrate may be a ceramic substrate.

In a specific implementation, the optical waveguide 24 is an optical waveguide manufactured by using a silicon, silicon nitride, or silicon oxide material.

In the optical component packaging apparatus provided in Embodiment 1, the packaging cavity 100 is formed through matching by the two packaging substrates, to package the optical component. Compared with a packaging apparatus using a metal case in the prior art, the optical component packaging apparatus provided in Embodiment 1 does not have a metal case, and therefore has lower production costs, and the production costs can further be reduced when the optical component is packaged through reflow soldering.

In addition, the optical waveguide 24 is disposed in the packaging substrate, and causes no impact on the sealing performance of the packaging cavity 100, the optical component in the packaging cavity 100 is coupled to the optical waveguide 24, and can implement optical switching with the outside by using the optical waveguide 24, so that optical input and output are implemented while the optical component is sealed. Therefore, based on the optical component packaging apparatus, hermetic package of the optical component with low costs is implemented and a problem of optical coupling output of the optical component is resolved.

### Embodiment 2

Based on a same invention concept, this embodiment provides an optical module, including an optical transmission end. The optical transmission end includes a fiber, and further includes the optical component packaging apparatus provided in Embodiment 1. The optical transmission end is coupled to a second coupling end of at least one optical waveguide in the optical component packaging apparatus.

In a specific implementation, butt-coupling, grating coupling, or evanescent wave coupling is performed on the optical transmission end and each optical waveguide, and the coupling manner is specifically selected based on the production costs of the optical component packaging apparatus and required coupling efficiency.

Similar to a principle in which hermetic package of the optical component with low costs is implemented and the problem of optical coupling output of the optical component is resolved based on the optical component packaging apparatus provided in Embodiment 1, based on the optical module provided in this embodiment, hermetic package of the optical component with low costs can also be implemented and the problem of optical coupling output of the optical component can also be resolved. For a specific implementation of the optical module provided in this embodiment, refer to Embodiment 1. Details are not described again.

### Embodiment 3

Based on a same invention concept, this embodiment provides an optical component packaging method according to claim 4, including:
coupling an optical component disposed between two opposite packaging substrates to an end face of a first coupling end of an optical waveguide in at least one packaging substrate in which the optical waveguide is disposed; and connecting two opposite surfaces of the two packaging substrates in a sealed manner, to form a packaging cavity around the optical component.

Specifically, in the packaging substrate provided with the optical waveguide, the end face of the first coupling end of each optical waveguide is disposed on an inner surface of the packaging cavity formed by the two connected packaging substrates, and each optical waveguide further includes a second coupling end whose end face is disposed on a surface that is of a corresponding packaging substrate and that is located outside the packaging cavity.

In a specific implementation, in the foregoing packaging method, first, the optical component may be coupled to the optical waveguide, and then the packaging cavity is formed around the optical component. FIG. 6 is a flowchart of a packaging method for an optical component according to Embodiment 3. The foregoing packaging method may be implemented according to the following steps:
Step S101. Couple an optical component disposed between two opposite packaging substrates to an end face of a first coupling end of each optical waveguide in at least one packaging substrate in which the optical waveguide is disposed. In a specific implementation, in this step, at least one optical waveguide is manufactured in the at least one packaging substrate.
Step S102. Connect two opposite surfaces of the two packaging substrates in a sealed manner, to form a packaging cavity around the optical component.

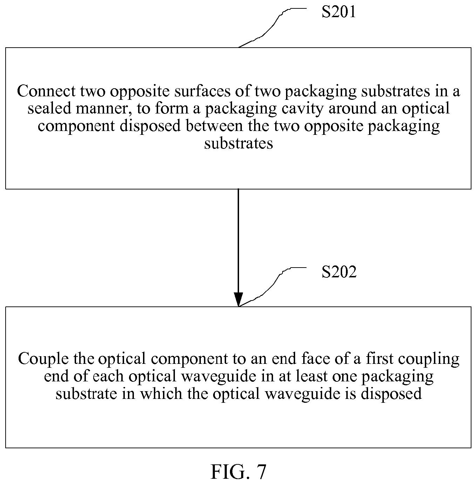

In another implementation, first, a packaging cavity may be formed around the optical component, and then the optical component is coupled to the optical waveguide. FIG. 7 is a flowchart of another packaging method for an optical component according to Embodiment 3. The foregoing packaging method may be implemented according to the following steps:
Step S201. Connect two opposite surfaces of two packaging substrates in a sealed manner, to form a packaging cavity around an optical component disposed between the two opposite packaging substrates.
Step S202. Couple the optical component to an end face of a first coupling end of each optical waveguide in at least one packaging substrate in which the optical waveguide is disposed. In a specific implementation, in this step, at least one optical waveguide may be formed in the at least one packaging substrate, and the optical waveguide is coupled to the optical component.

It should be noted that, the foregoing packaging method may be performed in an environment filled with a protective gas, or a protective gas may be injected into the packaging cavity after the packaging cavity is formed. Similarly, the foregoing packaging method may be implemented in a vacuum environment, or vacuum pumping is performed on the packaging cavity after the packaging cavity is formed.

According to the claimed invention, the connecting two opposite surfaces of two packaging substrates in a sealed manner, to form a packaging cavity around an optical component specifically includes:
connecting the two opposite surfaces of the two packaging substrates in a sealed manner by using a sealant, where the sealant is disposed around the optical component and forms a closed ring structure.

In a specific implementation, an adhesive may be selected as the foregoing sealant. To further improve sealing performance of the sealant and reduce production costs of the optical component packaging apparatus, according to the claimed invention, the two packaging substrates are connected through soldering and form the packaging cavity, and the connecting the two opposite surfaces of the two packaging substrates in a sealed manner by using a sealant specifically includes:
the sealant is a solder, disposing a ring pad on each of the two opposite surfaces of the two packaging substrates, where each ring pad is disposed around the optical component, and for a specific structure in which the packaging substrate is provided with a ring pad, refer to FIG. 2 and FIG. 3; and
disposing the solder on at least one of the two ring pads, and butting the two ring pads through soldering.

In a specific implementation, the soldering manner may be reflow soldering, to melt the solder and connect a first ring pad and a second ring pad. The reflow soldering is a common soldering process, and use of the protective gas in the reflow soldering is also a common process, so that the production costs of the optical component packaging apparatus are not additionally increased, and soldering between the first ring pad and the second ring pad may be integrated with another soldering process of the optical component, to further reduce the production costs of the optical component packaging apparatus. In a specific implementation, the protective gas may be nitrogen.

In a specific implementation, the foregoing solder may be a copper-zinc alloy solder, a silver-copper alloy solder, or a silver-copper-zinc alloy solder, and sealing performance of the solder is superior to that of an adhesive.

In another implementation that does not fall under the scope of the claims, the two packaging substrates may be directly connected in a manner such as splicing, or the sealant is replaced with a spacer having a specific thickness.

In the optical component packaging method provided in this embodiment, the packaging cavity is formed through matching by the two packaging substrates, to package the optical component. Compared with a packaging apparatus using a metal case in the prior art, the optical component packaging apparatus provided in this embodiment does not have a metal case, and therefore has lower production costs, and the production costs can further be reduced when the optical component is packaged through reflow soldering.

In addition, the optical waveguide is disposed in the packaging substrate, and causes no impact on sealing performance of the packaging cavity, the optical component in the packaging cavity is coupled to the optical waveguide, and can implement optical switching with the outside by using the optical waveguide, so that optical input and output are implemented while the optical component is sealed. Therefore, based on the optical component packaging method, hermetic package of the optical component with low costs is implemented and a problem of optical coupling of the optical component is resolved.

Obviously, a person skilled in the art can make various modifications and variations to the embodiments of the present invention without departing from the scope of this application. This application is intended to cover these modifications and variations of this application provided that they fall within the protection scope defined by the following claims of this application.

## Claims

1. An optical component packaging apparatus, comprising an optical component (10) and two packaging substrates (20, 30) disposed opposite to each other, wherein
a packaging cavity (100) filled with a protective gas is formed between the two packaging substrates (20, 30), and the optical component (10) is disposed in the packaging cavity (100); and
at least one packaging substrate (20, 30) is provided with an optical waveguide (24), an end face of a first coupling end (241) of each optical waveguide (24) is disposed on an inner surface of the packaging cavity (100) and is coupled to the optical component (10), and an end face of a second coupling end (242) of each optical waveguide (24) is disposed on a surface that is of a corresponding packaging substrate (20, 30) and that is located outside the packaging cavity (100);
wherein the packaging cavity (100) is formed through matching by two opposite surfaces (200, 300) of the two packaging substrates (20, 30) and a sealant (40) that is connected to the two opposite surfaces (200, 300) of the two packaging substrates (20, 30) in a sealed manner, and the sealant (40) is disposed around the optical component (10) and forms a closed ring structure;
wherein the two opposite surfaces (200, 300) of the two packaging substrates (20, 30) each are provided with a ring pad (22, 32), each ring pad (22, 32) is disposed around the optical component (10), and the sealant (40) is a solder and is connected to the two ring pads (22, 32);
wherein at least one packaging substrate is provided with a power supply circuit, a power output end (231) of the power supply circuit is located in the packaging cavity (100) and is connected to the optical component (10), and a power input end (232) of the power supply circuit is located outside the packaging cavity (100);
wherein the power supply circuit is disposed between the packaging substrate (20, 30) on which the power supply circuit is located and the ring pad (22, 32);
wherein the packaging cavity (100) comprises a first groove (21) disposed on the surface (200) of the first packaging substrate (20) and a second groove (31) disposed on the surface (300) of the second packaging substrate (30), said first groove (21) and said second groove (31) being configured to accommodate the optical component (10).

2. The optical component packaging apparatus according to claim 1, wherein the end face of the first coupling end (241) of each optical waveguide is disposed on an inner surface of a corresponding groove (21, 31).

3. An optical module, comprising an optical transmission end, and further comprising the optical component packaging apparatus according to any one of claims 1 to 2, wherein the optical transmission end is coupled to a second coupling end (242) of at least one optical waveguide (24) in the optical component packaging apparatus.

4. An optical component packaging method, comprising:
coupling (S101, S202) an optical component (10) disposed between two opposite packaging substrates (20, 30) to an end face of a first coupling end (241) of an optical waveguide (24) in at least one packaging substrate (20, 30) in which the optical waveguide (24) is disposed; and connecting (S102, S201) two opposite surfaces (200, 300) of the two packaging substrates (20, 30) in a sealed manner, to form a packaging cavity (100) around the optical component (10), wherein
the end face of the first coupling end (241) of each optical waveguide (24) is disposed on an inner surface of the packaging cavity (100), and each optical waveguide (24) further comprises a second coupling end (242) whose end face is disposed on a surface that is of a corresponding packaging substrate (20, 30) and that is located outside the packaging cavity (100).
wherein the connecting (S102, S201) two opposite surfaces (200, 300) of the two packaging substrates (20, 30) in a sealed manner, to form a packaging cavity (100) around the optical component specifically comprises:
matching the two opposite surfaces (200, 300) of the two packaging substrates (20, 30); and
connecting the two opposite surfaces (200, 300) of the two packaging substrates (20, 30) in a sealed manner by using a sealant (40), wherein the sealant (40) is disposed around the optical component (10) and forms a closed ring structure;
wherein the connecting the two opposite surfaces (200, 300) of the two packaging substrates (20, 30) in a sealed manner by using a sealant (40) specifically comprises:
disposing a ring pad (22, 32) on each of the two opposite surfaces (200, 300) of the two packaging substrates (20, 30), wherein the sealant (40) is a solder and each ring pad (22, 32) is disposed around the optical component (10); and
disposing the solder on at least one of the two ring pads (22, 32), and butting the two ring pads (22, 32) through soldering;
the method further comprising:
providing at least one packaging substrate (20, 30) with a power supply circuit, such that, a power output end (231) of the power supply circuit is located in the packaging cavity (100) and is connected to the optical component (10), and a power input end (232) of the power supply circuit is located outside the packaging cavity (100);
wherein the power supply circuit is disposed between the packaging substrate (20, 30) on which the power supply circuit is located and the ring pad (22, 32)
wherein the packaging cavity (100) comprises a first groove (21) disposed on the surface (200) of the first packaging substrate (20) and a second groove (31) disposed on the surface (300) of the second packaging substrate (30), said first groove (21) and said second groove (31) being configured to accommodate the optical component (10).

## Patentansprüche

1. Verpackungsvorrichtung für optische Komponenten, umfassend eine optische Komponente (10) und zwei Verpackungssubstrate (20, 30), die einander gegenüberliegend angeordnet sind, wobei
ein Verpackungshohlraum (100), der mit einem Schutzgas gefüllt ist, zwischen den zwei Verpackungssubstraten (20, 30) ausgebildet ist und die optische Komponente (10) in dem Verpackungshohlraum (100) angeordnet ist; und
mindestens ein Verpackungssubstrat (20, 30) mit einem Lichtwellenleiter (24) bereitgestellt ist, eine Endfläche eines ersten Kopplungsendes (241) jedes Lichtwellenleiters (24) auf einer inneren Oberfläche des Verpackungshohlraums (100) angeordnet ist und an die optische Komponente (10) gekoppelt ist und eine Endfläche eines zweiten Kopplungsendes (242) jedes Lichtwellenleiters (24) auf einer Oberfläche angeordnet ist, die einem entsprechenden Verpackungssubstrat (20, 30) angehört und die sich außerhalb des Verpackungshohlraums (100) befindet;
wobei der Verpackungshohlraum (100) mittels Zusammenpassens durch zwei gegenüberliegende Oberflächen (200, 300) der zwei Verpackungssubstrate (20, 30) und eines Dichtstoffs (40), der mit den zwei gegenüberliegenden Oberflächen (200, 300) der zwei Verpackungssubstrate (20, 30) in einer abgedichteten Weise verbunden ist, gebildet wird und der Dichtstoff (40) um die optische Komponente (10) herum angeordnet ist und eine geschlossene Ringstruktur bildet;
WOBEI DIE ZWEI GEGENÜBERLIEGENDEN OBERFLÄCHEN (200, 300) DER ZWEI VERPACKUNGSSUBSTRATE (20, 30) JEWEILS MIT EINEM RINGBELAG (22, 32) BEREITGESTELLT SIND, JEDER RINGBELAG (22, 32) UM DIE OPTISCHE KOMPONENTE (10) HERUM ANGEORDNET IST UND DER DICHTSTOFF (40) EIN LOT IST UND MIT DEN ZWEI RINGBELÄGEN (22, 32) VERBUNDEN IST;
wobei mindestens ein Verpackungssubstrat mit einer Leistungsversorgungsschaltung bereitgestellt ist, sich ein Leistungsausgangsende (231) der Leistungsversorgungsschaltung in dem Verpackungshohlraum (100) befindet und mit der optischen Komponente (10) verbunden ist und sich ein Leistungseingangsende (232) der Leistungsversorgungsschaltung außerhalb des Verpackungshohlraums (100) befindet;
wobei die Leistungsversorgungsschaltung zwischen dem Verpackungssubstrat (20, 30), auf dem sich die Leistungsversorgungsschaltung befindet, und dem Ringbelag (22, 32) angeordnet ist;
wobei der Verpackungshohlraum (100) eine erste Nut (21), die auf der Oberfläche (200) des ersten Verpackungssubstrats (20) angeordnet ist, und eine zweite Nut (31), die auf der Oberfläche (300) des zweiten Verpackungssubstrats (30) angeordnet ist, umfasst, wobei die erste Nut (21) und die zweite Nut (31) dazu konfiguriert sind, die optische Komponente (10) aufzunehmen.

2. Verpackungsvorrichtung für optische Komponenten nach Anspruch 1, wobei die Endfläche des ersten Kopplungsendes (241) jedes Lichtwellenleiters auf einer inneren Oberfläche einer entsprechenden Nut (21, 31) angeordnet ist.

3. Optisches Modul, umfassend ein optisches Übertragungsende und ferner umfassend die Verpackungsvorrichtung für optische Komponenten nach einem der Ansprüche 1 bis 2, wobei das optische Übertragungsende an ein zweites Kopplungsende (242) mindestens eines Lichtwellenleiters (24) in der Verpackungsvorrichtung für optische Komponenten gekoppelt ist.

4. Verpackungsverfahren für optische Komponenten, umfassend:
Koppeln (S101, S202) einer optischen Komponente (10), die zwischen zwei gegenüberliegenden Verpackungssubstraten (20, 30) angeordnet ist, an eine Endfläche eines ersten Kopplungsendes (241) eines Lichtwellenleiters (24) in mindestens einem Verpackungssubstrat (20, 30), in dem der Lichtwellenleiter (24) angeordnet ist; und Verbinden (S102, S201) zweier gegenüberliegender Oberflächen (200, 300) der zwei Verpackungssubstrate (20, 30) in einer abgedichteten Weise, um einen Verpackungshohlraum (100) um die optische Komponente (10) herum zu bilden, wobei
die Endfläche des ersten Kopplungsendes (241) jedes Lichtwellenleiters (24) auf einer inneren Oberfläche des Verpackungshohlraums (100) angeordnet ist und jeder Lichtwellenleiter (24) ferner ein zweites Kopplungsende (242) umfasst, dessen Endfläche auf einer Oberfläche angeordnet ist, die einem entsprechenden Verpackungssubstrat (20, 30) angehört und die sich außerhalb des Verpackungshohlraums (100) befindet,
wobei das Verbinden (S102, S201) zweier gegenüberliegender Oberflächen (200, 300) der zwei Verpackungssubstrate (20, 30) in einer abgedichteten Weise, um einen Verpackungshohlraum (100) um die optische Komponente herum zu bilden, insbesondere Folgendes umfasst:
Zusammenpassen der zwei gegenüberliegenden Oberflächen (200, 300) der zwei Verpackungssubstrate (20, 30); und
Verbinden der zwei gegenüberliegenden Oberflächen (200, 300) der zwei Verpackungssubstrate (20, 30) in einer abgedichteten Weise unter Verwendung eines Dichtstoffs (40), wobei der Dichtstoff (40) um die optische Komponente (10) herum angeordnet ist und eine geschlossene Ringstruktur bildet;
wobei das Verbinden der zwei gegenüberliegenden Oberflächen (200, 300) der zwei Verpackungssubstrate (20, 30) in einer abgedichteten Weise unter Verwendung eines Dichtstoffs (40) insbesondere Folgendes umfasst:
Anordnen eines Ringbelags (22, 32) auf jeder der zwei gegenüberliegenden Oberflächen (200, 300) der zwei Verpackungssubstrate (20, 30), wobei der Dichtstoff (40) ein Lot ist und jeder Ringbelag (22, 32) um die optische Komponente (10) herum angeordnet ist; und
Anordnen des Lotes auf mindestens einem der zwei Ringbeläge (22, 32) und Anschlagen der zwei Ringbeläge (22, 32) durch Löten;
wobei das Verfahren ferner Folgendes umfasst:
derartiges Bereitstellen mindestens eines Verpackungssubstrats (20, 30) mit einer Leistungsversorgungsschaltung, dass sich ein Leistungsausgangsende (231) der Leistungsversorgungsschaltung in dem Verpackungshohlraum (100) befindet und mit der optischen Komponente (10) verbunden ist und sich ein Leistungseingangsende (232) der Leistungsversorgungsschaltung außerhalb des Verpackungshohlraums (100) befindet;
wobei die Leistungsversorgungsschaltung zwischen dem Verpackungssubstrat (20, 30), auf dem sich die Leistungsversorgungsschaltung befindet, und dem Ringbelag (22, 32) angeordnet ist,
wobei der Verpackungshohlraum (100) eine erste Nut (21), die auf der Oberfläche (200) des ersten Verpackungssubstrats (20) angeordnet ist, und eine zweite Nut (31), die auf der Oberfläche (300) des zweiten Verpackungssubstrats (30) angeordnet ist, umfasst, wobei die erste Nut (21) und die zweite Nut (31) dazu konfiguriert sind, die optische Komponente (10) aufzunehmen.

## Revendications

1. Appareil d'encapsulation de composants optiques, comprenant un composant optique (10) et deux substrats d'encapsulation (20, 30) disposés en regard l'un de l'autre, dans lequel
une cavité d'encapsulation (100) remplie d'un gaz de protection est formée entre les deux substrats d'encapsulation (20, 30), et le composant optique (10) est disposé dans la cavité d'encapsulation (100) ; et
au moins un substrat d'encapsulation (20, 30) est pourvu d'un guide d'ondes optique (24), une face d'extrémité d'une première extrémité de couplage (241) de chaque guide d'ondes optique (24) est disposée sur une surface interne de la cavité d'encapsulation (100) et est couplée au composant optique (10), et une face d'extrémité d'une seconde extrémité de couplage (242) de chaque guide d'ondes optique (24) est disposée sur une surface qui est d'un substrat d'encapsulation correspondant (20, 30) et qui est située à l'extérieur de la cavité d'encapsulation (100) ;
dans lequel la cavité d'encapsulation (100) est formée par la mise en correspondance de deux surfaces opposées (200, 300) des deux substrats d'encapsulation (20, 30) et d'un matériau d'étanchéité (40) qui est relié aux deux surfaces opposées (200, 300) des deux substrats d'encapsulation (20, 30) de manière étanche, et le matériau d'étanchéité (40) est disposé autour du composant optique (10) et forme une structure annulaire fermée ;
dans lequel les deux surfaces opposées (200, 300) des deux substrats d'encapsulation (20, 30) sont chacune pourvues d'un bloc annulaire (22, 32), chaque bloc annulaire (22, 32) est disposé autour du composant optique (10), et le matériau d'étanchéité (40) est une soudure et est relié aux deux blocs annulaires (22, 32) ;
dans lequel au moins un substrat d'encapsulation est pourvu d'un circuit d'alimentation électrique, une extrémité de sortie de puissance (231) du circuit d'alimentation électrique est située dans la cavité d'encapsulation (100) et est reliée au composant optique (10), et une extrémité d'entrée de puissance (232) du circuit d'alimentation électrique est située à l'extérieur de la cavité d'encapsulation (100) ;
dans lequel le circuit d'alimentation électrique est disposé entre le substrat d'encapsulation (20, 30) sur lequel le circuit d'alimentation électrique est disposé et le bloc annulaire (22, 32) ;
dans lequel la cavité d'encapsulation (100) comprend une première rainure (21) disposée sur la surface (200) du premier substrat d'encapsulation (20) et une seconde rainure (31) disposée sur la surface (300) du second substrat d'encapsulation (30), ladite première rainure (21) et ladite seconde rainure (31) étant configurées pour recevoir le composant optique (10).

2. Appareil d'encapsulation de composants optiques selon la revendication 1, dans lequel la face d'extrémité de la première extrémité de couplage (241) de chaque guide d'ondes optique est disposée sur une surface interne d'une rainure correspondante (21, 31).

3. Module optique, comprenant une extrémité de transmission optique, et comprenant en outre l'appareil d'encapsulation de composant optique selon l'une quelconque des revendications 1 et 2, dans lequel l'extrémité de transmission optique est couplée à une seconde extrémité de couplage (242) d'au moins un guide d'ondes optique (24) dans l'appareil d'encapsulation de composants optiques.

4. Procédé d'encapsulation d'un composant optique, comprenant :
le couplage (S101, S202) d'un composant optique (10) disposé entre deux substrats d'encapsulation opposés (20, 30) à une face d'extrémité d'une première extrémité de couplage (241) d'un guide d'ondes optique (24) dans au moins un substrat d'encapsulation (20, 30) dans lequel le guide d'ondes optique (24) est disposé ; et la connexion (S102, S201) de deux surfaces opposées (200, 300) des deux substrats d'encapsulation (20, 30) de manière étanche, pour former une cavité d'encapsulation (100) autour du composant optique (10), dans lequel
la face d'extrémité de la première extrémité de couplage (241) de chaque guide d'ondes optique (24) est disposée sur une surface interne de la cavité d'encapsulation (100), et chaque guide d'ondes optique (24) comprend en outre une seconde extrémité de couplage (242) dont la face d'extrémité est disposée sur une surface qui est d'un substrat d'encapsulation correspondant (20, 30) et qui est située à l'extérieur de la cavité d'encapsulation (100),
dans lequel la connexion (S102, S201) de deux surfaces opposées (200, 300) des deux substrats d'encapsulation (20, 30) de manière étanche, pour former une cavité d'encapsulation (100) autour du composant optique comprend spécifiquement :
la mise en correspondance des deux surfaces opposées (200, 300) des deux substrats d'encapsulation (20, 30) ; et
la connexion des deux surfaces opposées (200, 300) des deux substrats d'encapsulation (20, 30) de manière étanche à l'aide d'un matériau d'étanchéité (40), dans lequel le matériau d'étanchéité (40) est disposé autour du composant optique (10) et forme une structure annulaire fermée ;
dans lequel la connexion des deux surfaces opposées (200, 300) des deux substrats d'encapsulation (20, 30) de manière étanche à l'aide d'un matériau d'étanchéité (40) comprend spécifiquement :
la disposition d'un bloc annulaire (22, 32) sur chacune des deux surfaces opposées (200, 300) des deux substrats d'encapsulation (20, 30), dans lequel le matériau d'étanchéité (40) est une soudure et chaque bloc annulaire (22, 32) est disposé autour du composant optique (10) ; et
la disposition de la brasure sur au moins l'un des deux blocs annulaires (22, 32), et la mise en butée des deux blocs annulaires (22, 32) par brasage ;
le procédé comprenant en outre :
la fourniture, à au moins un substrat d'encapsulation (20, 30), d'un circuit d'alimentation électrique, de sorte qu'une extrémité de sortie de puissance (231) du circuit d'alimentation électrique est située dans la cavité d'encapsulation (100) et est reliée au composant optique (10), et une extrémité d'entrée de puissance (232) du circuit d'alimentation électrique est située à l'extérieur de la cavité d'encapsulation (100) ;
dans lequel le circuit d'alimentation électrique est disposé entre le substrat d'encapsulation (20, 30) sur lequel est disposé le circuit d'alimentation électrique et le bloc annulaire (22, 32),
dans lequel la cavité d'encapsulation (100) comprend une première rainure (21) disposée sur la surface (200) du premier substrat d'encapsulation (20) et une seconde rainure (31) disposée sur la surface (300) du second substrat d'encapsulation (30), ladite première rainure (21) et ladite seconde rainure (31) étant configurées pour recevoir le composant optique (10).
